# EUROPEAN PATENT APPLICATION

(11) **EP 4 131 419 A1**
(43) Date of publication of application: **08.02.2023**
(21) Application number: 21189501.6
(22) Date of filing: 03.08.2021
(51) Int. Cl.: H01L 29/06, H01L 29/40, H01L 29/78

(54) **TRANSISTOR DEVICE**

(71) Applicant: Infineon Technologies Austria AG, 9500 Villach (AT)
(72) Inventor: FERRARA, Alessandro, 9500 Villach (AT); JOSIEK, Andrei, 01309 Dresden (DE); KROENKE, Matthias, 01109 Dresden (DE); TEGEN, Stefan, 01109 Dresden (DE)
(74) Representative: JENSEN & SON

(57) **Abstract**

In an embodiment, a transistor device is provided that comprises a semiconductor substrate having a first major surface, a cell field comprising a plurality of transistor cells and an edge termination region laterally surrounding the cell field. The transistor cells each comprise a drift region of a first conductivity type, a first body region of a second conductivity type opposing the first conductivity type on the drift region, a source region of the first conductivity type on the first body region and a gate electrode. The transistor device further comprises an elongate source contact having opposing first and second distal ends, the elongate source contact being in contact with the source region, and a second body region of the second conductivity type positioned in the semiconductor substrate. The second body region has a lateral extent such that it is spaced part from the second distal end of the elongate source contact and extends laterally beyond the first distal end of the elongate source contact.

## Description

### BACKGROUND

Transistor devices used in power electronic applications are often fabricated with silicon (Si) semiconductor materials. Common transistor devices for power applications include Si CoolMOS^{®}, Si Power MOSFETs and Si Insulated Gate Bipolar Transistors (IGBTs).

A transistor device for power applications may be based on the charge compensation principle and may include an active cell field including a plurality of trenches, each including a field plate for charge compensation. In some designs, the trenches and the mesas that are formed between adjacent trenches each have an elongate striped structure. Typically, the active cell field of the transistor device is laterally surrounded by an edge termination structure which serves to avoid breakdown of the semiconductor device due to edge effects and to improve the performance of the device. US 2017/0263718 A1 discloses an edge termination structure surrounding a high-voltage MOSFET for reducing a peak lateral electric field.

Avalanche breakdown is the phenomenon of current multiplication when a semiconductor device is subject to high electric fields. In the avalanche state, a high amount of power may be dissipated in the transistor device which may finally result in a destruction due to overheating if the avalanche current prevails longer than the time it takes to reach the thermal limit to overheat the transistor device.

In order to prevent damage to the transistor device, it is desirable that the avalanche breakdown occur over a large area, thereby reducing the avalanche current density. Discontinuities at the edges of semiconductor devices create locally large electric fields, tending to produce avalanche breakdown preferentially at the edge instead of uniformly distributed over the entire active area of the device. Edge termination structures are designed and fabricated to remove or smooth the discontinuities at the edge, thereby reducing the otherwise large fields at that location.

Avalanche breakdown can also occur in the cell field. If the voltage required to reach breakdown electric field is lower for one device region, e.g. in a group of cells, than for others, the critical temperature will be reached more easily causing the device to fail in one specific area. To increase avalanche robustness, the avalanche current should be shared among many cells/strips evenly.

Further improvements would be desirable to further improve the performance of transistor devices, including MOSFET devices, to achieve improved avalanche robustness.

### SUMMARY

According to the invention, a transistor device is provided that comprises a semiconductor substrate having a first major surface, a cell field comprising a plurality of transistor cells and an edge termination region laterally surrounding the cell field. The transistor cells each comprise a drift region of a first conductivity type, a first body region of a second conductivity type opposing the first conductivity type on the drift region, a source region of the first conductivity type on the first body region and a gate electrode. The transistor device further comprises an elongate source contact having opposing first and second distal ends, the elongate source contact being in contact with the source region, and a second body region of the second conductivity type positioned in the semiconductor substrate. The second body region has a lateral extent such that it is spaced part from the second distal end of the elongate source contact and extends laterally beyond the first distal end of the elongate source contact.

The second body region serves to increase the avalanche failure current and improve the avalanche robustness of the transistor device. The second body region has a lateral extent or area and is arranged with respect to the elongate source contact such that the second distal end of the elongate source contact is laterally spaced apart from the second body region and such that the second body region extends laterally beyond the first distal end of the elongate source contact. A peripheral portion of the second body region is positioned laterally adjacent to the first distal end of the elongate source contact. Thus, the peak of impact ionization is moved away from the first distal end of the elongate source contact and the avalanche robustness is improved.

In some embodiments, the second body region is arranged between the first body region and the drift region.

In some embodiments, the second body region is arranged above the first body region.

In some embodiments, the second body region and the first body region are positioned at substantially the same distance, i.e. depth, from the first major surface and are arranged such that the second body region laterally overlaps the first body region. In some embodiments, the second body region laterally overlaps the first body region along the length of the trench.

In some embodiments, the second body region has a vertical extent such that it is arranged above the first body region and also overlaps the first body region in the vertical direction, the vertical direction being substantially perpendicular to the first surface. Using the Cartesian coordinate system, the z direction is the vertical direction if the first surface is in the x-y plane and horizontal.

In some embodiments, the second body region has a vertical extent such that it is arranged below the first body region and also overlaps the first body region in the vertical direction.

In some embodiments, the second body region has a vertical extent such that it is arranged above and below the first body region and also overlaps the first body region in the vertical direction.

In some embodiments, the second body region laterally overlaps the elongate source contact by a distance d wherein the distance d is between 0.5 µm and 15µm. In some embodiments, the second body region overlaps the first distal end of the elongate source contact, but not the second distal end of the elongate source contact.

By overlapping the second body implant with the elongate source contact, rather than having the second body implant being laterally spaced apart from the elongate source contact, the peak of impact ionization can be moved away from the end of the source contact, improving the avalanche robustness further.

In some embodiments, the second body region has a greater doping concentration than a doping concentration of the first body region.

In some embodiments, the doping concentration of the second body region is substantially constant along the length of the source contact or increases in a direction from the cell field into the edge termination region or increases from the second distal to the first distal end of the elongate source contact.

In some embodiments, the doping concentration of the second body region is substantially constant over the area or lateral extend of the second body region. In some embodiments, the doping concentration of the second body region increases in a direction from the cell field into the edge termination region.

In some embodiments, the source region has a lateral extent and the elongate source contact is arranged such that its second distal end is in contact with the source region and its first distal end is laterally arranged outside of the lateral extent of the source region.

In some embodiments, the second body region is laterally spaced apart from the source region.

In some embodiments, the second body region is positioned in an inactive region of the semiconductor substrate.

In some embodiments, the second body region is positioned in the edge termination region. In some embodiments, the second body region is positioned in the edge termination region and laterally outside of the cell field. In some embodiments, the second body region is positioned in the edge termination region laterally outside of the cell field and laterally inward of an edge termination trench. In some embodiments, the second body region is positioned exclusively in the edge termination region.

In some embodiments, the second body region is positioned laterally within the boundary of the cell field. In some embodiments, the second body region is positioned exclusively within the boundary of the cell field. The total area or lateral extent of the second body region is, however, less than the area defined by the boundary of the cell field so that some of the area of the cell field is free from the second body region. The active switching area of the transistor device is free from the second body region.

In some embodiments, the second body region is positioned in the edge termination region and in a portion of the cell field.

In some embodiments, the cell field comprises a plurality of elongate trenches that extend from the first major surface into the semiconductor substrate and elongate mesas, each elongate mesa being formed between neighbouring elongate active trenches. The first body region and the source region are formed in the mesa and the elongate source contact is arranged on the mesa. An elongate mesa including the first body region and the source region and its associated elongate trench form an active mesa and an active trench, respectively.

In some embodiments, the gate electrode is positioned in the elongate trench.

In some embodiments, the transistor device further comprises a field plate positioned in the elongate trench and the gate electrode is arranged above and is electrically insulated from the field plate.

In some embodiments, the transistor device further comprises a field plate positioned in the elongate trench and the gate electrode is a planar gate positioned on the mesa.

In some embodiments, the transistor device further comprises a field plate positioned in the elongate trench and the gate electrode is positioned in a gate trench formed in the mesa.

In some embodiments, the second body region has in plan view a tapered form having a tip.

In some embodiments, the tip of the tapered second body region is positioned above the elongate mesa. In some embodiments, the tip of the tapered second body region is aligned with the midline of the length of the elongate mesa.

In some embodiments, the tip of the tapered second body region is positioned above the elongate trench. In some embodiments, the tip of the tapered second body region is aligned with the midline of the length of the elongate trench.

In some embodiments, the second body region comprises a plurality of subsections arranged in a row and spaced apart by gaps.

The row of subsections extends in a lateral direction, for example along the length of a mesa. In some embodiments, each subsection is a discrete area of island of the second conductivity type that is positioned in the mesa at substantially the same depth from the first major surface.

In some embodiments, the transistor device further comprises a gate metallization structure positioned on the first major surface. In some embodiments, the gate metallization structure is positioned in the edge termination region. The second body region is positioned under the gate metallization structure.

In some embodiments, the transistor device further comprises a gate finger positioned on the first major surface in the cell field and electrically connected to the gate electrode and the second body region is positioned under the gate finger.

In some embodiments, the transistor device further comprises a source finger positioned on the first major surface in the cell field and electrically connected to the source regions and the second body region is positioned under the source finger.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1A illustrates a top view of a transistor device.
Figure 1B illustrates an enlarged top view of a portion of the top surface of the transistor device of figure 1A.
Figure 1C illustrates a cross-sectional view along the line A-A indicated in figure 1B.
Figure 1D illustrates a cross-sectional view along the line B-B indicated in figure 1B.
Figure 1E illustrates a cross-sectional view of a transistor device according to an embodiment.
Figure 1F illustrates a cross-sectional view of a transistor device according to an embodiment.
Figure 2A illustrates a cross-sectional view of a planar gate transistor structure according to an embodiment.
Figure 2B illustrates a cross-sectional view of a trench gate transistor structure according to an embodiment.
Figure 3A illustrates an enlarged top view of a portion of a transistor device including a second body implant according to an embodiment.
Figure 3B illustrates an enlarged top view of a portion of a transistor device including a second body implant according to an embodiment.
Figure 3C illustrates an enlarged top view of a portion of a transistor device including a second body implant according to an embodiment.
Figure 4A illustrates a top view of a transistor device including a second body implant according to an embodiment.
Figure 4B illustrates a top view of a transistor device including a second body implant according to an embodiment.
Figure 5 illustrates a top view of a transistor device including a second body implant according to an embodiment.
Figure 6 illustrates a top view of a transistor device including a second body implant according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

A transistor device is optimized for switching applications and typically has a voltage rating indicating the voltage at which the transistor device may be safely operated. When the transistor device is off, it is capable of blocking a certain voltage, such as 100V, 120V or 150V, known as the blocking voltage or BVDSS for a particular drain source current (I_{DS}). When the transistor device is on, it has a sufficiently low on-resistance (RON) for the application in which it is used, i.e., it experiences sufficiently low conduction loss when a substantial current passes through the device.

Some types of transistor device, such as a MOSFET, include a cell field comprising a plurality of substantially identical transistor cells, each having a transistor structure. The cells are electrically connected to form a single transistor device for switching. The cell field provides the active area of the transistor device within the semiconductor die in which the transistor device is formed. The transistor device includes an edge termination region that laterally surrounds the cell field and that has a structure that serves to reduce the peak lateral electric field between the cell field and the side faces of the transistor device, i.e. the side faces of the semiconductor die, to avoid breakdown of the semiconductor device due to edge effects and to improve the performance of the device.

A Power MOSFET with improved avalanche robustness is provided. According to the invention, a second body region is provided in addition to the first body region of the MOSFET. The second body region is positioned laterally adjacent to and in some embodiments also overlaps a portion of a contact to the source region. The second body region has a lateral extent such that it is not positioned under a further portion of the source contact, for example under the portion of the source contact that is in contact with the source region.

This invention increases the avalanche failure current by an additional body implant in the non-active areas of the chip, where the source contact is interrupted. This method only requires one extra lithography layer and body implant, so that the process cost is not significantly increased. Optimizing the body implant layout, energy and dose allows the avalanche destruction current to be increased, for example up to a factor 2. Since the extra body is not implanted in the active area, other MOSFET electrical parameters (Rdson, Vth, Qg, Qgd) are not affected.

By overlapping the second body implant with the source contact, rather than having the second body implant being laterally spaced apart from the source contact, the peak of impact ionization can be moved away from the contact end, improving the avalanche robustness further. Typical overlap values are between 0.5µm and 15µm. Overlap values larger than 10µm are also possible, depending on the design of the transistor device and location of the source contacts.

In some embodiments, the shape of the second body mask and, therefore, the lateral extent, shape and position of the second body region in the semiconductor substrate fabricated using the second body mask can be adjusted. In some embodiments, the second body mask overlaps the source contact and in other embodiments, the second body mask stops before the source contact. In some embodiments, the position on the semiconductor substrate or chip of the second body region is adjusted. For example, the second body region may be positioned exclusively in the edge termination region, exclusively in the cell field or both in the cell field and in the edge termination region. The energy/dose of the second body implant can be adjusted. The layout of the second body implant can be adjusted to implement a graded second body implant to smoothen the transition into the regions where the second body is not implanted.

The second body region can be positioned in all regions of the chip where the source contacts are interrupted. Different positions are possible, for example at the gate edge, in edge termination region overlapped by gate metal, e.g. the gate pad or external gate runner, at the last contacts in mesa regions at the edge of the stripe array where the source contacts are not covered by the source mask, at a gate finger, i.e. at an internal gate metal in the middle of the trench array, where the source contacts are interrupted to allow the gate contacts, at the source edge, e.g. at the edge termination region not covered by gate metal and fully covered by source metal, at a source finger, i.e. a region in the middle of the trench array where the source contacts are interrupted to allow the field-plate contacts.

This arrangement of a second body region improves the avalanche robustness of the transistor device and has advantages over alternative methods of improving the avalanche robustness. For example, there is no increase in RonA as the thickness of the epitaxial layer is not increased. Also, the current density does not need to be decreased by increasing the transistor cell pitch or the active area. Additional gate/source finger connections are not required so that a resulting loss of active area is avoided. In addition, other avalanche failure modes can be addressed. For example, additional gate and/or source connections can only improve avalanche if the failure mechanism is related to dynamic effects, such as dynamic return-on or travelling potentials on the source field-plates. An increase of contact width/depth is not required which has the drawback of RonA increase, BVDSS loss, wider threshold voltage distribution. Contact optimization leads to smaller improvements in the avalanche robustness than the method shown in this invention. A contact that is too deep or too wide can even cause a reduction in the avalanche current.

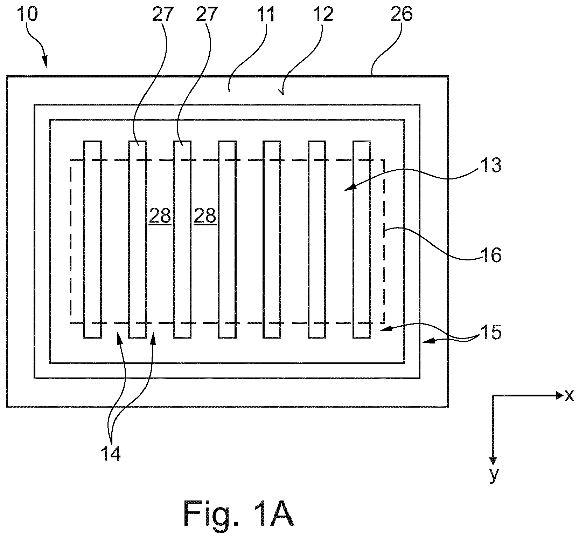

Figure 1A illustrates a top view of a transistor device 10 which includes a semiconductor substrate 11 having a first major surface 12, a cell field 13 comprising a plurality of transistor cells 14 and an edge termination region 15 which laterally surrounds the cell field 13. The transition between the cell field 13 and the edge termination region 15 is indicated in figure 1A by the dashed line 16.

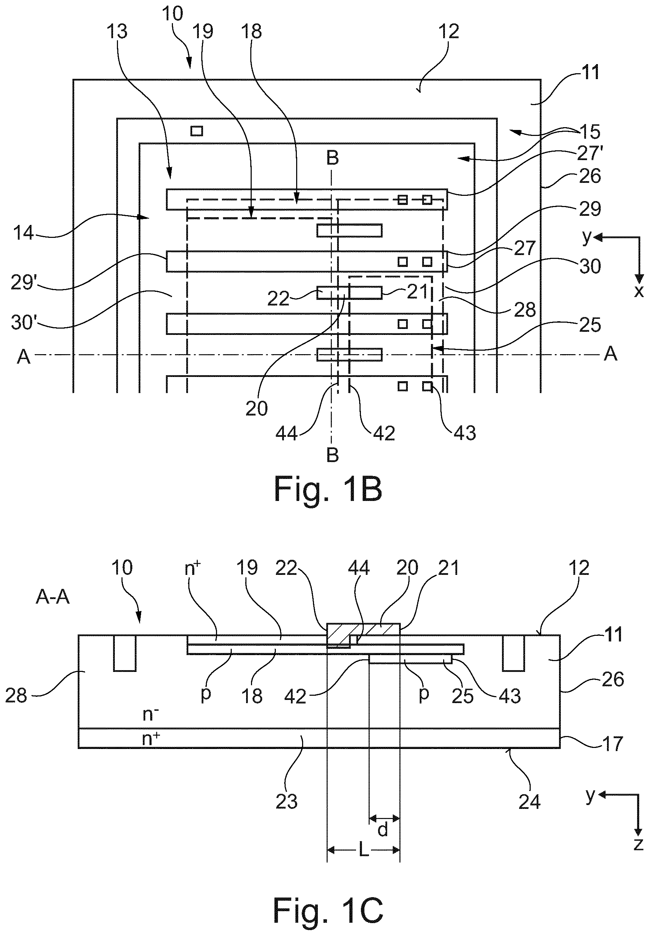

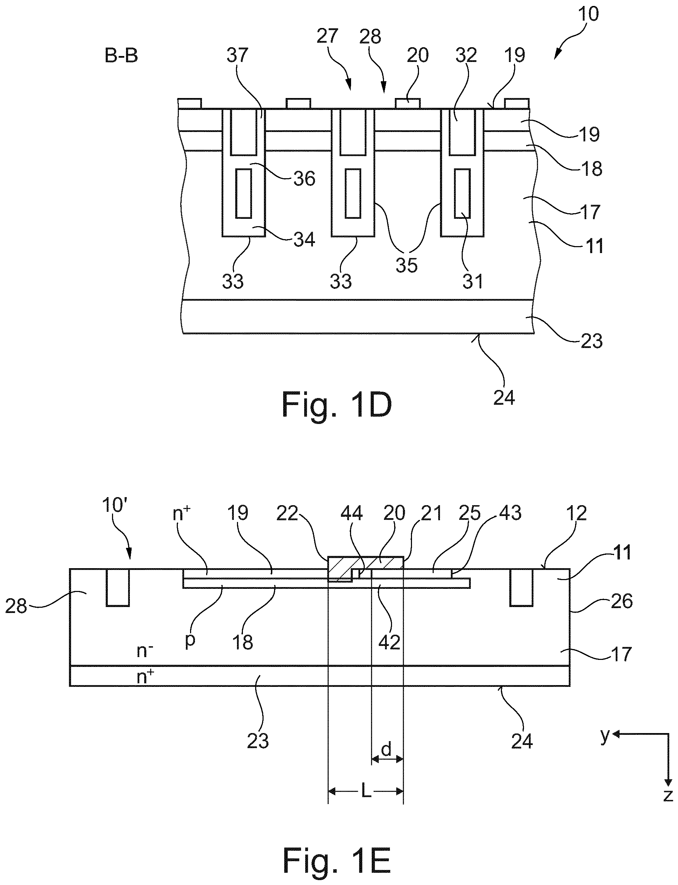

Figure 1B illustrates an enlarged top view of a portion of the first major surface 12 of the transistor device 10 of figure 1A, Figure 1C illustrates a cross-sectional view along the line A-A indicated in figure 1B and Figure 1D illustrates a cross-sectional view along the line B-B indicated in figure 1B.

The semiconductor substrate 11 may be formed of silicon and may be formed of monocrystalline silicon or an epitaxial silicon layer. The semiconductor substrate 11 may also be called a semiconductor die or semiconductor chip. The transistor device 10 may be a MOSFET device, whereby the term MOSFET is not limited to a metal oxide semiconductor FET, but also includes metal insulator semiconductor FETs.

The transistor cells 14 are coupled in parallel to form the active switching area of the transistor device 10. Each transistor cell 14 comprises a transistor structure. As can be seen in the cross-sectional view of figures 1C and 1D, each transistor cell 14 comprises a drift region 17 of the first conductivity type, for example n-type, a first body region 18 of a second conductivity type, which opposes the first conductivity type, for example p-type if the first conductivity type is n-type. The first body region 18 is positioned on the drift region 17 and a source region 19 of the first conductivity type is arranged on the body region 18. Each transistor cell 14 also comprises a gate electrode 32, which can be seen in the cross-sectional view of figure 1D. The transistor device 10 further includes a drain region 23 of the first conductivity type at its second major surface 24 which opposes the first major surface 12. The source region 19 and the drain region 23 are more highly doped than the drift region 17. The first major surface 12 is the front surface and the second major surface 24 is the rear surface of the semiconductor substrate or chip in this embodiment.

Referring to the cross-sectional view of figure 1C and the enlarged view of figure 1B, the transistor device 10 further comprises an elongate source contact 20 which has a first distal end 21 and an opposing second distal end 22. The elongate source contact 20 is in electrical contact with the source region 19.

The transistor device 10 further includes a second body region 25 which is doped with the second conductivity type and which is positioned in the semiconductor substrate 11. The second body region 25 is positioned vertically between the first body region 18 and the drift region 17. The second body region 25 is positioned deeper in the semiconductor substrate 11 from the first major surface 12 than the first body region 18. In some embodiments, the second body region 25 forms an interface with the first body region 18 and with the drift region 17. In other embodiments, the second body region 25 is positioned vertically above the first body region 18.

The second body region 25 has a doping concentration which is greater than a doping concentration of the first body region 18. For example, the first body region 18 may have a doping concentration within the range of 1e¹⁷cm⁻³ to 1e¹⁸cm⁻³ and the second body region 25 may have a doping concentration in the range of 1e¹⁷cm⁻³ to 1e²⁰cm⁻³, whereby the condition that the second body region 25 has a higher doping concentration than the first body region 18 remains.

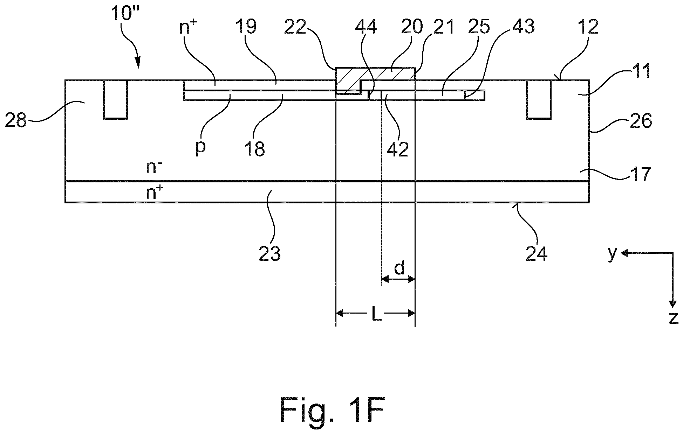

In some embodiments, such as that described with reference to figure 1, the first distal end 21 of the elongate source contact 20 faces towards the edge termination region 15 and towards the side face 26 of the semiconductor substrate 11. The opposing second distal end 22 faces towards the cell field 13.

The second body region 25 has a lateral extent, which can be seen in the top view of figure 1B, such that it is spaced apart from the second distal end 22 of the elongate contact and extends laterally beyond the first distal end 21 of the elongate source contact 20.

In some embodiments, the second body region 25 overlaps the first distal end 21 of the elongate source contact 20 such that the second body region 25 is positioned vertically under a portion of the elongate source contact 20 including the first distal end 21 but not underneath a further portion of the elongate source contact 20 including the second distal end 22. The second body region 25 extends beyond the first distal end 21 of the elongate source contact 20 such that it has a peripheral portion that is arranged laterally adjacent the second distal end 22.

Referring to figures 1A, 1B,1D, 1E and 1F in some embodiments, the transistor cells 14 include a trench structure such that the cell field 13 comprises a plurality of elongate strip-like trenches 27 which extend substantially parallel to one another. An elongate strip-like mesa 28 is formed between sidewalls 35 of adjacent ones of each of the trenches 27. The elongate trenches 27 each have a length that is greater than its width and have opposing distal ends 29, 29'. The mesas 28 also each have a length that is greater than its width and have opposing distal ends 30, 30'. The first body region 18, source region 19 and the drift region 17 are formed in the semiconductor material of the mesas 28 as can be seen in the cross-sectional view of figure 1D.

In some embodiments, the second body region 25 has a lateral extent such that it extends over some of the semiconductor mesas 28 but not between the mesa 28' formed between the outermost trench 27' of the plurality of trenches 27 and the next adjacent trench 27 of the plurality of trenches 27. In contrast, the first body region 18 has a larger lateral extent and is positioned in all the semiconductor mesas 28 and extends over nearly the entire length of the trenches 27 and mesas 28. The opposing distal ends 29, 29' of the trenches and distal ends 30, 30' of the semiconductor mesas 28 may be positioned laterally outside of the first doped body region 18 and, therefore, in the edge termination region 15.

The source region 19 has a lateral extent that is smaller than the lateral extent of the first body region 18. The source region 19 is also laterally spaced apart from the second body region 25 such that there is no vertical overlap between the source region 19 and the second body region 25. The second body region 25 vertically overlaps the first body region 18 over only part of the lateral extent of the second body region 25 and over only part of the lateral extent of the first body region 18.

In some embodiments, the second body region 25 overlaps the elongate source contact 20 by a distance d. The distance d may be between 0.5 µm and 15 µm. The second body region 25 is positioned underneath the first body region 18 and underneath the elongate source contact 20 in the vertical direction or z direction using the Cartesian coordinate system indicated in figure 1. The length L of the elongate source contact 20 and length of the trenches 27 and mesas 28 extends in the x direction and the width of the trenches 27 and mesas 28 in the y direction using the Cartesian coordinate system indicated in figure 1. The remainder of the length L of the source elongate source contact 20 in its longest direction, that is the distance L-d, is arranged laterally adjacent the second body region 25 in the y direction. The distance d of the overlap between the elongate source contact 20 and the second body region 25 is less than a length L of the elongate source contact 20.

The doped source region 19 formed in the semiconductor substrate, in particular the elongate mesas 28, has a lateral extent. In some embodiments, the elongate source contact 20 is arranged such that the second distal end 22 is in contact with the source region 19 and the first body region 18 and such that the first distal end 21 is arranged laterally outside and spaced apart from the source region. Such an arrangement is illustrated in figure 1C. The position and lateral extent or area of the source region 19 determines the active area of the transistor device 10.

In some embodiments, the second body region 25 is positioned in an inactive region of the semiconductor substrate 11 and may be positioned exclusively in an inactive region of the semiconductor substrate 11. An inactive region of the semiconductor substrate 11 is a region of the semiconductor substrate 11 which does not contribute to the switching of the transistor device 10. For example, an inactive region of the semiconductor substrate 11 may be any region in which the source region 19 is not positioned. For example, in the embodiment illustrated in figure 1C, the second distal end 22 of the elongate source contact 20 is positioned on and in contact with the source region 19 and is, therefore, positioned in the active rea of the transistor device 10. The opposing first distal end 21 is, however, positioned laterally adjacent and spaced apart from the source region 19 and is not in contact with the source region 19. Therefore, a portion of the elongate source contact 20 is positioned above a region of the semiconductor substrate 11 which does not include a source region 19 and which is therefore inactive. The second boy region 25 is positioned in this inactive area and is laterally spaced apart from the source region 19, i.e. spaced apart from the source region 19 in the x-y plane.

In embodiments in which the lateral extent of the second body region 25 is such that its second end 42 which is positioned facing towards but spaced apart from the end 44 of the source region 19 and such that its opposing first end 43 is positioned facing towards the side face 26 of the semiconductor substrate 11, the second body region 25 is positioned exclusively in an inactive region of the semiconductor substrate 11. In some embodiments, the second body region 25 is positioned in the edge termination region 15 and may be positioned exclusively in the edge termination region 15. In some embodiments, the cell field 13 may include discrete regions which do not contribute to the switching of the transistor device 10 and are therefore inactive regions. These inactive regions are free of the source region 19. The second body region 25 is arranged in these inactive regions of the cell field 13 in which the source region 19 is omitted.

The transistor cells 14 of the cell field 13 may have different structures. Figure 1D illustrates a cross-sectional view of a cell field 13 in which each trench 27 comprises a field plate 31 and the gate electrode 32. The field plate 31 is positioned towards the base 33 of the trench 27 and is electrically insulated from the semiconductor material of the semiconductor substrate 11 by a dielectric layer 34 which lines the sidewalls 35 and the base 33 of the trench 27. The gate electrode 32 is positioned in the upper portion of the trench 27 above the field plate 31 and is electrically insulated from the field plate 31 by intervening dielectric layer 36 and from the semiconductor material of the semiconductor substrate 11 by a further dielectric layer 37 positioned on the sidewalls 35 in the upper portion of the trench 27 which forms the gate dielectric material. The gate dielectric material 37 has a thickness which is less than the thickness of the dielectric layer 34 providing the electrical insulation of the field plate 31 from the semiconductor substrate 11.

As can be seen in the cross-sectional view figure 1D, the elongate source contact 20 is positioned on the mesa 28 formed between sidewalls 35 of adjacent ones of the trenches 27. The source contact 20 is positioned on the upper surface 12 of the mesas 28 and on the source region 19 which is in turn positioned on the body region 18 which is in turn positioned on the drift region 17.

In some embodiments, the elongate source contact 20 extends into the semiconductor substrate 11 through the source region 19 and to make contact with the body region 18 as can be seen in the cross-sectional view of figure 1C.

Figure 1E illustrates a cross-sectional view of a transistor device 10' according to an alternative embodiment. The transistor device 10' differs from the arrangement illustrated in figure 1C in that the second body region 25 is arranged vertically above the first body region 18, i.e. above the first body region 18 in the z direction, rather than below the first body region 18 as shown in figure 1C.

Similar to the embodiment illustrated with reference to figures 1A to 1D, the second body region 25 also has a lateral extent such that its second end 42 is positioned facing towards but spaced apart from the end 44 of the source region 19 and such that its opposing first end 43 is positioned facing towards the side face 26 of the semiconductor substrate 11. The second body region also overlaps the elongate source contact 20 by a distance d.

Figure 1F illustrates a cross-sectional view of a transistor device 10" according to a further alternative embodiment. The transistor device 10'' differs from the arrangement illustrated in figure 1C and 1D in that the second body region 25 is arranged at approximately the same vertical position within the semiconductor substrate 11 as the first body region 18, i.e. the body region 18 and second body region 25 are arranged at substantially the same depth in the z direction from the first major surface 12. The second body region 25 laterally overlaps the first body region 18. The position of the second body region 25 can be identified by reason of a higher doping concentration in a defined localised region.

Similar to the embodiments illustrated with reference to figures 1A to 1E, the second body region 25 also has a lateral extent such that its second end 42 is positioned facing towards but spaced apart from the end 44 of the source region 19 and such that its opposing first end 43 is positioned facing towards the side face 26 of the semiconductor substrate 11. The second body region also overlaps the elongate source contact 20 by a distance d.

The second body region 25 may have differing extents in the vertical direction, i.e. in a direction perpendicular to the first surface. In other non-illustrated embodiments, be located within the semiconductor body 11 such that it is positioned above and overlaps with the first body region 18 in the vertical direction, or such that it is positioned below and overlaps with the first body region 18 in the vertical direction, or such that it is positioned above, below and overlaps with the first body region 18 in the vertical direction.

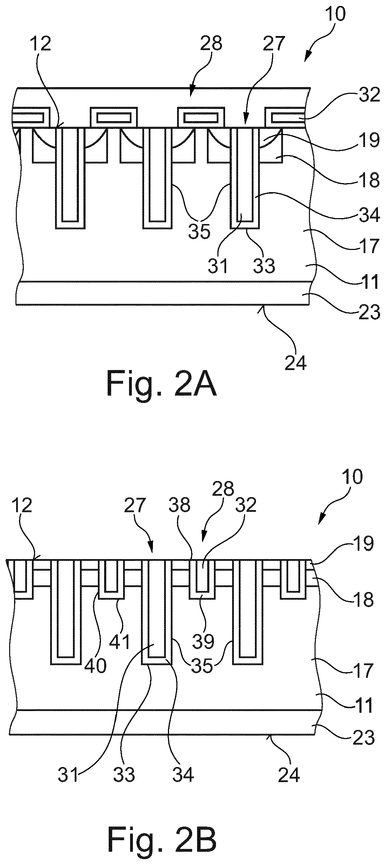

In other embodiments, such as that illustrated in figure 2A, the transistor device 10 has a planar gate structure in place of a trench gate structure. Each of the elongate trenches 27 includes a field plate 31 which extends to or nearly to the front surface 12 of the semiconductor substrate 11. The gate electrode 32 is positioned on the front surface 12 of the semiconductor substrate 11 on the mesas 28. In these embodiments, the body region 18 and source region 19 have the form of wells positioned on each side of the elongate trenches 27.

In some embodiments, such as that illustrated in figure 2B, the gate electrode 32 is positioned in a further gate trench 38 that is separate from the elongate trenches 27. The field plate 31 is positioned in the elongate trenches 27 as in the embodiment illustrated in figure 2A. The gate trench 38 is positioned in the mesa 28 between two elongate trenches 27 in which a field plate 31 is positioned. The gate trench 38 has an elongate form such that it extends substantially parallel to the elongate trenches 27. The gate trench 38 has a depth which is less than the depth of the elongate trenches 27. The gate trench 38 is lined with dielectric material 39 on its side walls 40, which forms the gate oxide of the MOSFET, and on its base 41.

In the embodiment illustrated in figure 1, the second body region 25 has a substantially rectangular shape in plan view, i.e. when viewed from the top, and has a doping concentration that is substantially constant over its entire area and is therefore substantially constant along the length L of the source contact 20 under which it is situated.

In other embodiments, the doping concentration of the second body region 25 increases in a direction along the length L of the source contact 20 and in some embodiments along the length L of the elongate source contact 20 in a direction from the cell field 13 towards the edge termination region 15. In some embodiments, the doping concentration of the second body region 25 increases in a direction from the second distal end 22 towards the first distal end 21 of the elongate source contact 20. In the embodiment illustrated in figure 1, the direction from the second distal end 22 to the first distal end 21 of the elongate source contact 20 corresponds to the direction from the cell field 13 towards the edge termination region 15.

The doping concentration can be adjusted by adjustment of the implantation conditions used to implant the dopant the second conductivity type into the second body region 25.

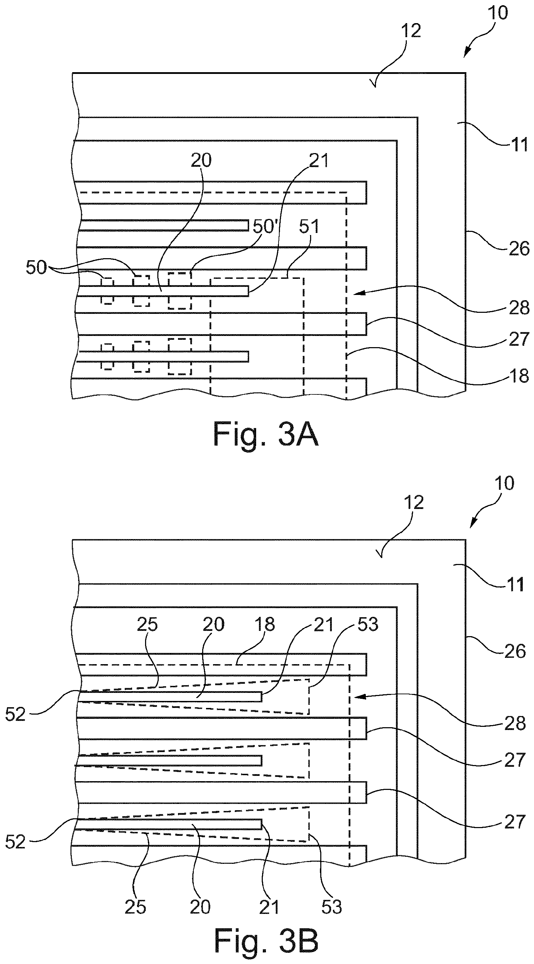

The second body region 25 may have different lateral forms in plan view. Figure 3A illustrates an embodiment in which the second body region 25 comprises a plurality of subsections 50. Each subsection 50 is a discrete area spaced apart from other subsections by a portion of the semiconductor substrate which is free of the second body region 25. The subsections 50 of the second body region 25 are arranged in a row and spaced apart by gaps in which the second body region 25 is not positioned. The subsections 50, which are implanted with the dopant of the second conductivity type to form the second body region 25, are positioned in the mesa 28 and the row is aligned with and positioned underneath the source contact 20. The subsections 50 are positioned within the mesa 28 at substantially the same depth from the first major surface 12 and vertically between the first body region 18 and the drift region 17. The lateral area of the individual discrete subsections 50 is such that each subsection 50 is positioned within the width of the mesa 28. In some embodiments, the lateral area of the individual discrete subsections 50 progressively decreases in a direction from the edge termination region 15 towards the cell field 13 and in a direction from the first distal end 21 towards the second distal end 22 of the source contact 20. In addition, the second body region 25 may include a further subsection 51 which, in some embodiments, is rectangular in plan view and which is positioned under and overlaps the first distal end 21 of the elongate source contact 20 and extends laterally beyond the first distal end 21 towards the edge termination region 15. The additional rectangular area 51 is spaced apart from the outermost subsection 50' of the discrete subsections 50. The subsection 51 is positioned at the same depth from the first major surface 12 as the subsections 50 and vertically between the first body region 18 and the drift region 17.

In some embodiments, such as that illustrated in figure 3B, the second body region 25 has in plan view a tapered form having a tip 52 and a wider end 53 which opposes the tip 52. In the plan view, the second body region 25 can be considered to have a triangular form. The second body region 25 is positioned vertically between the first body region 18 and the drift region 17. As illustrated in figure 3B, the tip 52 is positioned in the elongate mesa 28 and is symmetrically aligned with the midline 54 of the mesa 28 and of the elongate source contact 20. The wider base 53 is positioned laterally adjacent the first distal end 21 of the elongate source contact 20 such that the second body region 25 overlaps the first distal end 21. The triangular contour of the second body region 25 is positioned and has a lateral extent or area such that it is laterally spaced apart from and does not overlap the second distal end 22 of the elongate source contact 20. The tip 52 is positioned underneath and intermediate the length of the elongate source contact 20.

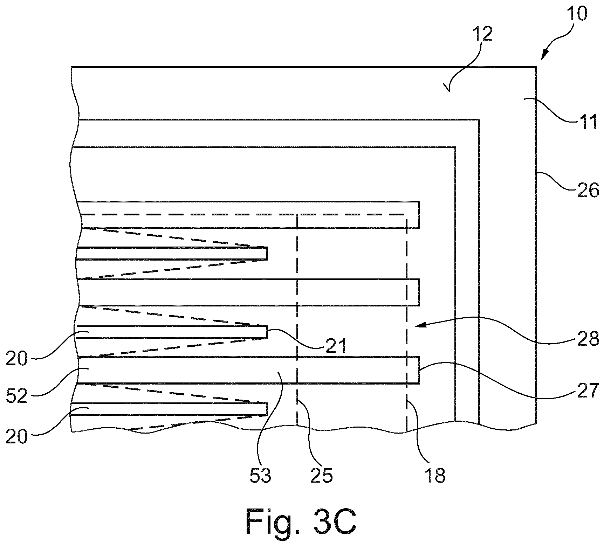

Referring to figure 3C, in other embodiments in which the second body region 25 has a tapered form having a tip 52 wider end 53, the tip 52 is positioned above the elongate trench 27 in plan view. The tip 52 and tapered form may be symmetrically aligned with the midline 55 of the trench 27. The wider end 53 is again positioned laterally adjacent the first distal end 21 of the elongate source contact 20 such that the second body region 25 is positioned underneath and overlaps the first distal end 21 of the source elongate source contact 20 but the tip 52 is laterally spaced apart and does not overlap with the second distal end 22 of the elongate source contact 20.

Referring to the embodiments of the plan views described with reference to figure 3, the second body region 25 may be positioned vertically below or vertically above (in the z direction) the first body region 18. In other embodiments, the second body region 25 may also be positioned at substantially the same depth from the first major surface 12 as the first body region 18.

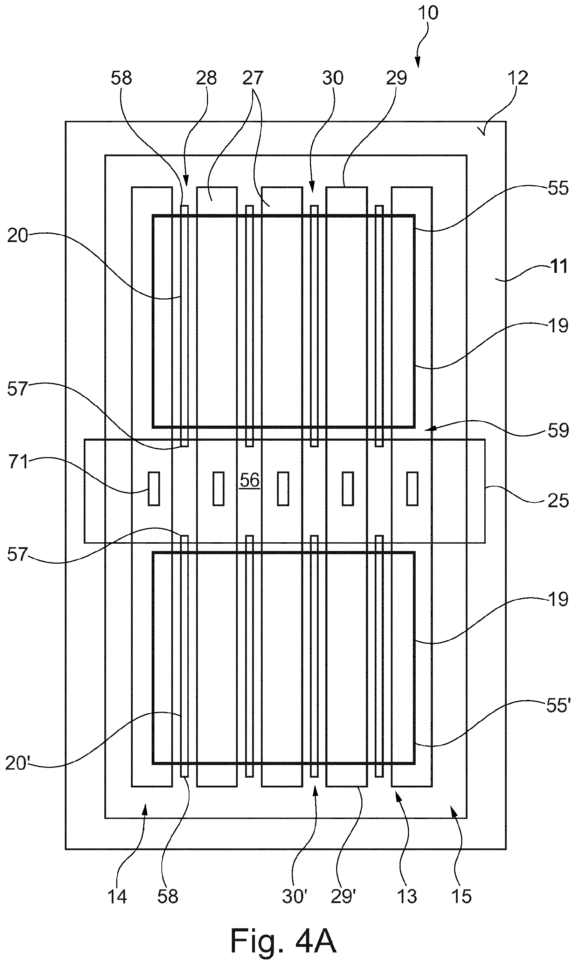

Figure 4A illustrates a top view of a transistor device 10 according to an embodiment. In this embodiment, two elongate source contacts 20, 20' are provided on each mesa 28 and are spaced apart by a gap 56 positioned intermediate the length of the mesa 28, for example at the centre of the length of the mesa 28. The transistor device 10 includes two strip like source metallisation regions 55, 55' that are laterally spaced apart from one another by a gap 59 and which extend substantially perpendicularly to the long direction of the mesas 28. One source metallization region 55 is positioned at the first distal end 30 of the mesas 28 and electrically couples the elongate source contacts 20 at those ends 30 of the mesas 28 to one another. The second source metallization region 55' is positioned at the opposing distal ends 30' of the mesas 28 and electrically couples the elongate source contacts 20' at the opposing end 30' of the mesas 28 to one another.

The transistor device 10 includes further contacts 71, at least one of which is positioned above each of the trenches 27. The contact 71 electrically contacts the field plate 31 positioned within the trench 27. In this embodiment, the contacts 71 for the field plates 31 are positioned towards the centre of the length of the trenches 27 and laterally adjacent the gaps 56 between the elongate source contacts 20, 20'. In this embodiment, the second body region 25 is positioned intermediate the length of the mesas 28 and towards the lateral centre of the length of the mesas 28 and therefore towards the lateral centre of the cell field 13. In this embodiment, the second body region 25 has a rectangular form and extends substantially perpendicular to the length of the trenches 27 and mesas 28. The second body region 25 has a lateral extent or area such that it overlaps the distal end 57 of each of the elongate source contacts 20, 20' which faces towards the centre of the first major surface 12 of the semiconductor substrate 11.

In this embodiment, using the terminology used in the description of figure 1, the distal end 57 of the source contact 20, 20' forms the first distal end since it overlaps the second body region 25. The overlap between the second body region 25 and the inner distal end 57 may be around 0.5 to 15 µm as in the embodiments illustrated in figures 1 to 3. The remainder of the length of the elongate source contact 20 including the opposing outer distal end 58, which forms the second distal end using the terminology of figure 1, is arranged laterally adjacent to and spaced apart from the second body region 25 and is therefore not positioned vertically above the second body region 25. The second body region 25 is laterally spaced apart from the source region 19 and the source metallization 55. The source region 19 is positioned under and has a lateral extent that corresponds to the source metallization strips 55.

In this embodiment, the source region 19 is omitted from the centre region of the length of the mesas 28 such that this region is inactive and does not contribute towards the switching of the transistor device 10. The second body region 25 is positioned in an inactive region of the semiconductor substrate 11 since this central portion of the cell field 13 does not contribute to the switching of the transistor device 10. In this embodiment, the transistor device 10 can be considered to include two sub-cell fields which are arranged laterally adjacent to one another, with each sub-cell field including one elongate source contact 20 and one source metallisation region 55.

In other non-illustrated embodiments, the elongate source contact 20 or a further source contact is positioned intermediate the length of the mesas 28 and the source metallization 55 has the form of a source runner that extends perpendicularly to the length of the mesas 28, intermediate the length of the mesas 28 and above the source contact. The second body region is omitted from the region of the semiconductor substrate 11 and region of the cell field 13 underneath the source runner.

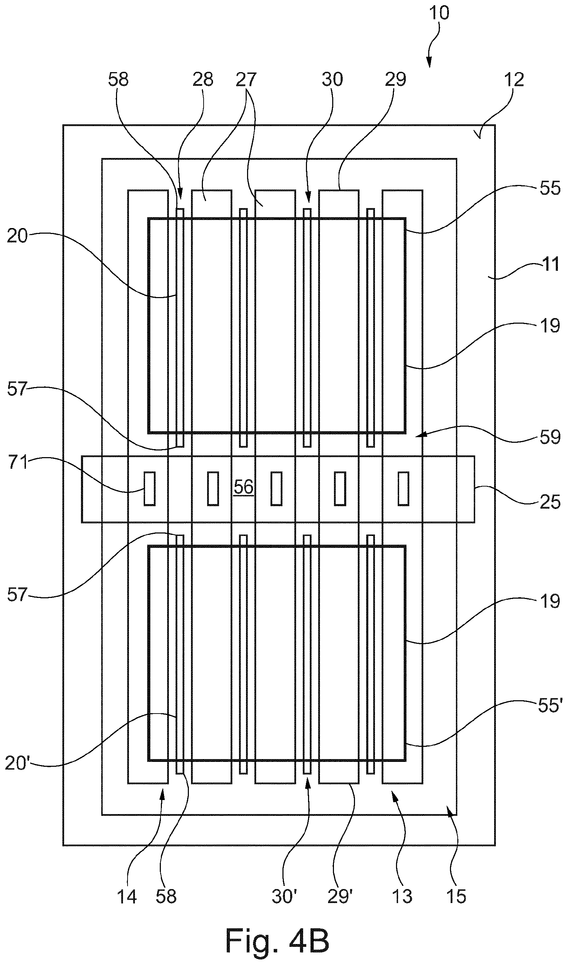

Figure 4B illustrates a top view of a transistor device 10 according to an embodiment. The transistor device 10 of figure 4B has a similar design as that illustrated in figure 4A in that it includes two strip like source metallisation regions 55, 55' that are laterally spaced apart from one another by a gap 59 and which extend substantially perpendicularly to the long direction of the mesas 28. One source metallization region 55 is positioned at the first distal end 30 of the mesas 28 and electrically couples the elongate source contacts 20 at those ends 30 of the mesas 28 to one another. The second source metallization region 55' is positioned at the opposing distal ends 30' of the mesas 28 and electrically couples the elongate source contacts 20' at the opposing end 30' of the mesas 28 to one another.

The transistor device 10 includes further contacts 71, at least one of which is positioned above each of the trenches 27. The contact 71 electrically contacts the field plate 31 positioned within the trench 27. The contacts 71 for the field plates 31 are positioned towards the centre of the length of the trenches 27 and laterally adjacent the gaps 56 between the elongate source contacts 20, 20'. The second body region 25 is positioned intermediate the length of the mesas 28 and towards the lateral centre of the length of the mesas 28 and therefore towards the lateral centre of the cell field 13. The second body region 25 has a rectangular form and extends substantially perpendicular to the length of the trenches 27 and mesas 28.

The transistor device 10 illustrated in figure 4B differs from that illustrated in figure 4A in that the second body region 25 has a lateral extent or area such that it is spaced apart from the distal end 57 of each of the elongate source contacts 20, 20' which faces towards the centre of the first major surface 12 of the semiconductor substrate 11.

The overlap between the second body region 27 and the distal ends 57, 57' of the source contacts 20, 20' is achieved not by the sizing and positioning of the mask, as shown in figure 4B, used for implanting the second body region 27, but by thermal diffusion of the second body implant during manufacturing such that in the final device, the second body region 27 overlaps the source contacts 20, 20'.

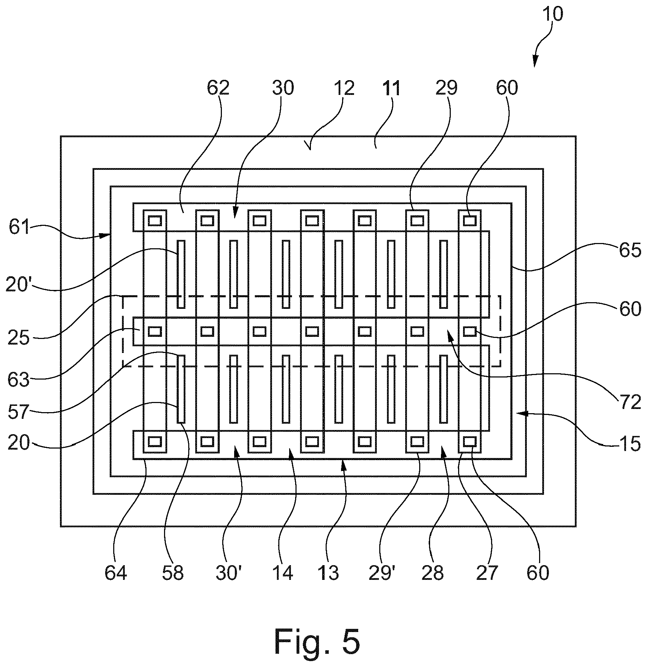

Figure 5 illustrates an embodiment of a transistor device 10 in which gate contacts 60 are positioned at the two opposing ends and intermediate the length of the trenches 27. Each trench includes three gate contacts 60. Two source metal contacts 20, 20' are arranged on each mesa 28 towards the opposing distal ends 30, 30' of the mesas 28 such that they are spaced apart by a gap 72. The central metal gate contact 60 is positioned laterally adjacent the gap 72 between the elongate source metal contacts 20, 20'. In this embodiment, the gate metallisation structure 61 on the first major surface 12 includes three sections or runners 62, 63, 64 which extend substantially perpendicular to the length of the trenches 27. The first gate runner 62 extends substantially perpendicular to a first distal end 29 of the trenches 27 and electrically connects the gate contacts 60 arranged at this end 29 of the trench. The second gate runner 63 extends above and electrically connects the gate contacts 60 positioned intermediate the length of the trenches 27. The third gate runner is positioned towards the opposing distal end 29' of the trenches 27 and electrically connects the gate contacts 60 at this opposing end 29' of the trenches 27 to one another. The three gate fingers 62, 63, 64 are electrically connected to one another by a further metal gate runner 65 that extends perpendicularly to the three metal gate runners 62, 63, 64 and that is positioned in the edge termination region 15. The gate runners 62, 63, 64 may also be referred to as gate fingers and are positioned on the cell field 13.

In this embodiment, the second body region 25 has a substantially rectangular form and is positioned intermediate the length of the trenches 27 and mesas 28 and, in some embodiments, towards the centre of the length of the trenches 27 and mesas 28. The second body region 25 has a lateral extent such that it is positioned under the distal ends 57 of the two elongate source contacts 20, 20' of the mesas 28 as in the embodiment illustrated in figure 4A and such that it is positioned under the second gate runner 63. The second body region 25 is spaced apart from the source region 19 and from the source metallization strips 55.

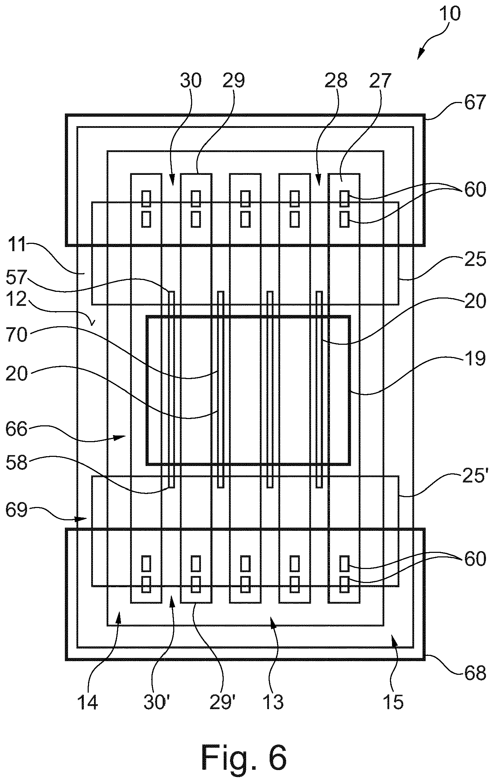

Figure 6 illustrates a top view of a transistor device 10 in which the source metal contact 20 of each mesa 28 is positioned intermediate the length of the mesas 28 and towards the centre of the length of the mesas 28. One or more contacts 60 to the gate electrode 32 within the trenches 27 are positioned at the opposing distal ends 29, 29' of the trenches 27. In this embodiment, two second body regions 25, 25' are provided.

The two second body regions 25, 25' are spaced apart from one another at the centre of the cell field 13 by a gap 66. In this embodiment, first and second gate metal runners 67, 68 are provided which extend substantially perpendicularly to the length of the trenches 28 and which are spaced apart from one another by a gap 69. The first gate metal strip 67 electrically couples the gate metal contacts 60 positioned at one distal end 29 of the trenches 27 and the second gate metal strip 68 electrically couples the gate metal contacts 60 positioned at the opposing distal end 29' of the trenches 27.

One second body region 25 overlaps the distal end 57 of the single elongate source contact 20 and extends along the length of the mesa 28 towards the distal end 30 of the mesas 28 but fails to overlap the opposing distal end 58 of the elongate source contact 20. The other second body region 25' overlaps the opposing distal end 58 of the single source elongate source contact 20 and extends along the length of the mesa 28 towards the opposing distal end 30' of the mesas 28 but fails to overlap the distal end 57 of the elongate source contact 20.

The central portion 70 of the source contact 20 is not positioned above either of the second body regions 25, 25'. The source region 19 is positioned in this central portion 70 and is spaced apart from both of the second body regions 25, 25'.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A transistor device (10), comprising:
a semiconductor substrate (11) having a first major surface (12), a cell field (13) comprising a plurality of transistor cells (14) and an edge termination region (15) laterally surrounding the cell field (13), wherein the transistor cells (14) each comprise a drift region (17) of a first conductivity type, a first body region (18) of a second conductivity type opposing the first conductivity type on the drift region (17), a source region (19) of the first conductivity type on the first body region (18) and a gate electrode (32);
an elongate source contact (20) having opposing first and second distal ends (21, 22), the elongate source contact (20) being in contact with the source region (19);
a second body region (25) of the second conductivity type positioned in the semiconductor substrate (11) and having a lateral extent such that the second body region (25) is spaced part from the second distal end (22) of the elongate source contact (20) and extends laterally beyond the first distal end (21) of the elongate source contact (20) .

2. A transistor device (10) according to claim 1, wherein
the second body region (25) is arranged between the first body region (18) and the drift region (17), and/or
the second body region (25) is arranged between above the first body region (18), and/or
the second body region (25) and the first body region (18) are arranged at substantially the same depth from the first major surface.

3. A transistor device (10) according to claim 1 or claim 2, wherein the second body region (25) laterally overlaps the elongate source contact (20) by a distance d wherein the distance d is between 0.5 µm and 15µm.

4. A transistor device (10) according to any one of clams 1 to 3, wherein the second body region (25) has a doping concentration has a greater doping concentration than a doping concentration of the first body region (18).

5. A transistor device (10) according to any one of claims 1 to 4, wherein the doping concentration of the second body region (25) is substantially constant along the length of the elongate source contact (20) or increases in a direction from the cell field (13) into the edge termination region (15) or increases from the second distal end (22) to the first distal end (21) of the elongate source contact (20).

6. A transistor device (20) according to any one of claims 1 to 5, wherein the source region (19) has a lateral extent and the elongate source contact (20) is arranged such that the second distal end (22) is in contact with the source region (19) and the first distal end (21) is laterally arranged outside of the lateral extent of the source region (19), wherein the second body region (25) is laterally spaced apart from the source region (19).

7. A transistor device (10) according any one of claims 1 to 6, wherein the second body region (15) is positioned in an inactive region of the semiconductor substrate (11).

8. A transistor device (10) according to claim 7, wherein the second body region (25) is positioned in the edge termination region (15).

9. A transistor device (10) according to one of claims 1 to 8, wherein the cell field (13) comprises:
a plurality of elongate trenches (27) that extend from the first major surface (12) into the semiconductor substrate (11);
elongate mesas (28), each active mesa (28) being formed between neighbouring elongate active trenches (27),
wherein the first body region (18) and the source region (19) are formed in the mesa (28) and the elongate source contact (20) is arranged on the mesa (28).

10. A transistor device (10) according to claim 9, wherein the gate electrode (32) is positioned in the elongate trench (27) .

11. A transistor device (10) according to claim 10, further comprising a field plate (31) positioned in the elongate trench (27), the gate electrode (32) being arranged above and electrically insulated from the field plate (31).

12. A transistor device according to claim 9, further comprising a field plate (31) positioned in the elongate trench (27), wherein the gate electrode (32) is a planar gate positioned on the mesa (28) or the gate electrode (32) is positioned in a gate trench (38) formed in the mesa (28).

13. A transistor device (10) according to any one of claims 9 to 12, wherein the second body region (25) has in plan view a tapered form having a tip (52), wherein the tip (52) is positioned in the elongate mesa (28) or in the elongate trench (27).

14. A transistor device (10) according to any one of claims 9 to 13, wherein the second body region (25) comprises a plurality of subsections (50) arranged in a row and spaced apart by gaps.

15. A transistor device (10) according to any one of claims 7 to 14 further comprising:
a gate metallization (61) positioned on the first major surface (12) in the edge termination region (15), wherein the second body region (25) is positioned under the gate metallization (61), and/or
a gate finger (63) positioned on the first major surface (12) in the cell field (13) and electrically connected to the gate electrode (32), wherein the second body region (25) is positioned under the gate finger (63), or
a source finger (55) positioned on the first major surface (12) in the cell field (13) and electrically connected to the field plates (31) wherein the second body region (25) is positioned under the source finger (55).
